# FASCICULE DE BREVET EUROPEEN

(11) **EP 2 782 429 B1**
(45) Date de publication et mention de la délivrance du brevet: **03.06.2015**
(21) Numéro de dépôt: 14156447.6
(22) Date de dépôt: 25.02.2014
(51) Int. Cl.: H05G 2/00

(54) **Procédé et systeme de fabrication d'une cible pour l'emission de rayonnements de photons, notamment de rayons X, ou de particules notamment de protons ou d'electrons, par tir laser**
Verfahren und Vorrichtung zur Herstellung eines Targets für die Emission von Photonenstrahlung, insbesondere Röntgenstrahlung oder Partikeln, insbesondere Protonen oder Elektronen, durch Laserbeschuss
Method and system of manufacturing a target for emission of photon radiation, particularly x-rays, or particles, particularly proptons or electrons by laser bombardment.

(30) Priorité: 20.03.2013 FR 1352501
(43) Date de publication de la demande: 24.09.2014
(73) Titulaire: COMMISSARIAT A L'ENERGIE ATOMIQUE ET AUX ENERGIES ALTERNATIVES, 75015 Paris (FR)
(72) Inventeur: Perin, Jean-Paul, 38180 SEYSSINS (FR)
(74) Mandataire: Cabinet Laurent & Charras

(56) Documents cités:
- JP-A- H05 258 692
- JP-A- 2006 332 552
- US-A1- 2008 157 011

## Description

### DOMAINE DE L'INVENTION

L'invention concerne le domaine de l'émission de rayons X, ou de particules, notamment protons et électrons, et plus particulièrement la fabrication de cibles utilisées lors d'une telle émission.

### ETAT DE LA TECHNIQUE

Un principe connu de production de rayons X consiste à focaliser un faisceau laser sur une cible en métal massive, de préférence un métal de numéro atomique élevé, par exemple de l'or, du cuivre ou tout autre métal dense. L'interaction du faisceau laser et du métal génère ainsi un plasma et une émission de rayons X mono-énergétique qui sont utilisés notamment en mammographie ou en angiographie. La cible est usuellement disposée dans une enceinte sous vide, où se produit l'interaction laser/matière, et est montée sur un support mobile, par exemple tournant, afin que chaque tir laser impacte une portion de la cible non impactée lors d'un tir précédent.

Lorsque la cible métallique présente une épaisseur élevée, notamment supérieure à 500 nanomètres, les rayons X sont émis dans le demi-espace où se propage le faisceau laser. On parle alors de « rétro-émission ». En revanche, lorsque la cible métallique présente une faible épaisseur, notamment une épaisseur inférieure à 500 nanomètres, les rayons sont émis dans le sens du faisceau laser, et par conséquent sont émis par la face de la cible métallique opposée à celle impactée par le faisceau laser. On parle alors d'émission « en transmission ».

Usuellement, les cibles métalliques minces sont obtenues en déposant une couche de métal sur un support, en cuivre ou en plastique, puis le substrat est ensuite éliminé au moyen d'un bain chimique et/ou d'une gravure par plasma. La couche ainsi libérée est ensuite lavée, par exemple dans de l'eau ou de l'alcool, afin d'éliminer un maximum d'impuretés, puis la cible est montée sur le support mobile, et le support est monté dans l'enceinte.

Une telle fabrication est longue et l'étape de retrait du substrat est en outre très délicate. De plus, il est nécessaire d'introduire la cible et son support dans l'enceinte, ce qui suppose de casser le vide existant dans celle-ci, puis de reformer le vide, ce qui prend également beaucoup du temps. En pratique, le temps d'utilisation d'un système d'émission de rayons X est très limité, et son temps d'immobilisation important.

Des problèmes analogues se posent pour la génération de particules, par exemple des électrons et des protons, à l'aide de tir laser sur une cible mince.

### EXPOSE DE L'INVENTION

Le but de la présente invention est de proposer un procédé de fabrication d'une cible pour la génération de rayonnements de photons ou de particules, notamment la génération de rayons X, d'électrons ou de protons, qui ne nécessite pas le retrait d'un support physique de la cible métallique, et qui peut être mis en oeuvre directement dans une enceinte sous vide, et notamment l'enceinte sous vide utilisée pour l'émission des rayonnements ou des particules.

A cet effet, l'invention a pour objet un procédé de fabrication d'une cible pour la génération de rayonnements de photons ou de particules par laser, comportant :
▪ la réalisation d'un support comprenant une première et une seconde faces et traversé par des ouvertures ; et
▪ la formation dans une enceinte hermétique d'une couche de matériau sur la première face du support.

Selon l'invention, la formation de la couche de matériau sur le support comporte :
▪ la protection de la première face du support par un élément de protection;
▪ l'injection dans l'enceinte d'un gaz de matériau de remplissage ;
▪ le réglage de la pression dans l'enceinte et de la température du support de manière à former des bouchons solides de matériau de remplissage dans les ouvertures du support;
▪ l'arrêt de l'injection du gaz de matériau de remplissage dans l'enceinte ;
▪ le maintien de la température du support et de la pression dans l'enceinte à des valeurs conservant les bouchons solides dans les ouvertures du support, et conjointement audit maintien :
   o le retrait de l'élément de protection de la première face du support de manière à libérer celle-ci; et
   o la formation de la couche de matériau sur la première face du support et sur les bouchons solides remplissant les ouvertures ;
▪ la modification des conditions de pression dans l'enceinte et de température et du support de manière à libérer les ouvertures du support des bouchons solides.

En d'autres termes, un support plein est formé en remplissant des ouvertures préexistantes du support, la couche, par exemple métallique, formant la cible est réalisée sur le support plein ainsi crée, puis le matériau de remplissage des ouvertures est retiré. Les portions de la couche métallique recouvrant les ouvertures forment alors les zones de la cible ultérieurement impactées par le faisceau laser afin de produire des rayons (X), ou des particules (protons ou électrons). Le support n'est donc pas retiré et peut par exemple consister directement en le support mobile utilisé pour présenter au faisceau laser des zones de la cible qui sont vierges de tout impact. Par ailleurs, le matériau de remplissage sous forme solide peut être facilement ôté une fois la couche déposée, par exemple en modifiant la pression dans l'enceinte et/ou la température du support afin de sublimer le matériau de remplissage.

En outre, le matériau de remplissage peut être introduit sous forme gazeuse dans l'enceinte sous vide utilisée pour l'émission de rayons ou de particules, et la couche de matériau peut être directement formée dans cette enceinte au moyen, par exemple, d'un dépôt physique en phase vapeur.

Selon un mode de réalisation, la première face du support est plane, et la protection de celle-ci comprend le plaquage de la première face du support contre une surface plane et pleine.

Selon un mode de réalisation, la mise en présence du support avec le gaz comprend le placement du support dans une enceinte hermétique de pression réduite prédéterminée et le refroidissement du support à une température inférieure à la température du point triple du matériau constitutif du gaz.

Selon un mode de réalisation, la couche de matériau est déposée sur la première face du support au moyen d'un dépôt physique en phase vapeur. La phase vapeur du métal est par exemple produite par le chauffage ohmique d'un support sur lequel repose une masse solide du métal ou par le bombardement électronique d'une cible constituée du métal.

Notamment, l'enceinte hermétique comporte des moyens aptes à injecter le gaz dans l'enceinte, des moyens aptes à régler la pression interne de celle-ci, des moyens aptes à régler la température du support à des températures inférieures au point triple du matériau constitutif du gaz, et des moyens aptes à vaporiser un élément métallique solide placé au contact de ceux-ci. En outre, la mise en contact du support avec le gaz, la formation des bouchons remplissant les ouvertures du support et le dépôt physique en phase vapeur sont réalisés dans l'enceinte en maintenant une pression réduite, notamment inférieure à 10⁻³ mbar.

Selon un mode de réalisation, le retrait de l'élément de protection de la première face du support comprend l'échauffement de ce dernier de manière à désolidariser l'élément des bouchons solides remplissant les ouvertures du support et l'éloignement de l'élément de protection de la première face du support.

Selon un mode de réalisation, la libération des ouvertures du support comporte les réglages de la température du support et/ou de la pression dans l'enceinte. Notamment, le support est réchauffé au-dessus du point de sublimation du matériau de remplissage et l'enceinte est maintenue à une pression inférieure à la pression de saturation correspondant à la température du support.

Selon un mode de réalisation, le matériau de remplissage est de l'argon, de l'azote, du krypton, ou du xénon.

Selon un mode de réalisation, la couche de matériau est métallique. Plus particulièrement, l'épaisseur de la couche de matériau métallique est inférieure ou égale à 500 nanomètres, et de préférence inférieure ou égale à 50 nanomètres.

En variante, la couche de matériau comporte une couche métallique et une couche de dihydrogène ou de deutérium. Plus particulièrement, la couche métallique a une épaisseur comprise entre 20 nanomètres et 100 nanomètres, et la couche de dihydrogène ou de deutérium a une épaisseur comprise entre 20 nanomètres et 100 nanomètres.

Selon un mode de réalisation, les ouvertures du support sont des cônes tronqués s'évasant depuis la première face du support vers la seconde face du support.

Selon un mode de réalisation, des ouvertures du support sont disposées en cercle et angulairement espacées de manière régulière.

L'invention a également pour objet un système pour la mise en oeuvre d'un procédé de fabrication d'une cible pour la génération de rayonnements, notamment de rayons X ou de particules, notamment de protons ou d'électrons par laser, du type précité, comportant :
▪ une enceinte hermétique ;
▪ un support et des moyens de positionnement du support dans l'enceinte ;
▪ un élément de protection et des moyens de positionnement de l'élément de protection dans l'enceinte entre une position de retrait et une position de plaquage de l'élément de protection contre la face du support;
▪ des moyens de pompage du volume interne de l'enceinte ;
▪ des moyens de commande de la température du support ;
▪ des moyens d'injection de gaz dans l'enceinte ;
▪ des moyens de chauffage de l'élément de protection ; et
▪ des moyens de vaporisation d'un élément métallique dans l'enceinte.

Selon un mode de réalisation, les moyens de positionnement du support dans l'enceinte comportent des moyens de mise en rotation de ce dernier.

Selon un mode de réalisation, l'enceinte comporte une fenêtre transparente au faisceau laser disposée en regard de la face du support.

### BREVE DESCRIPTION DES FIGURES

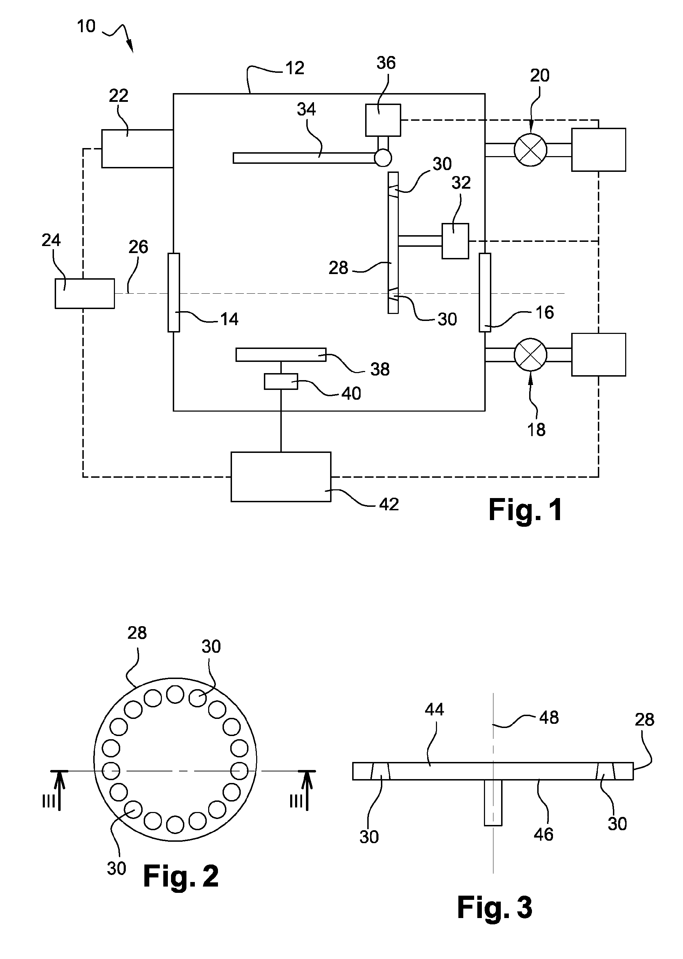

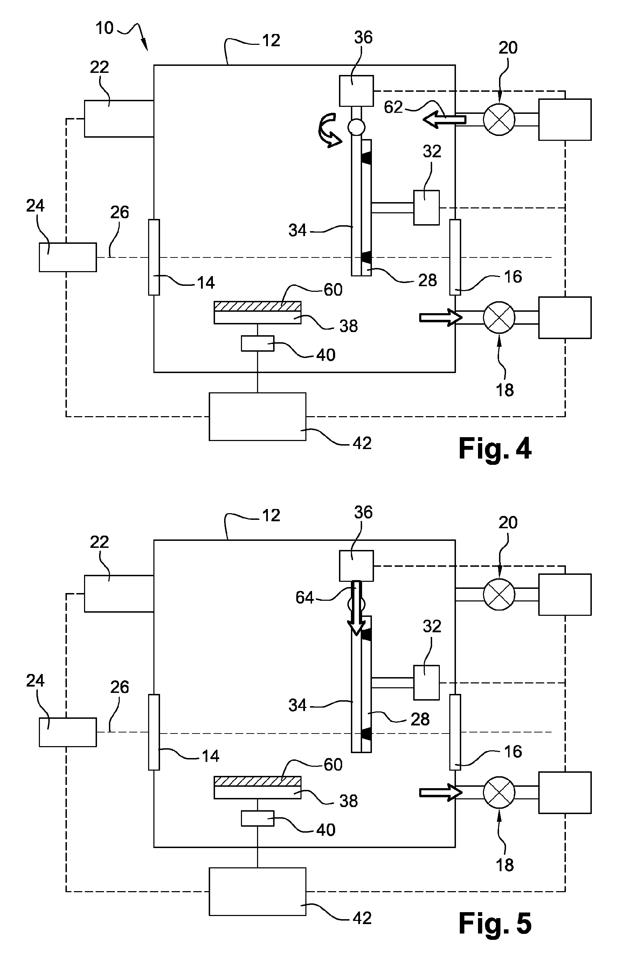

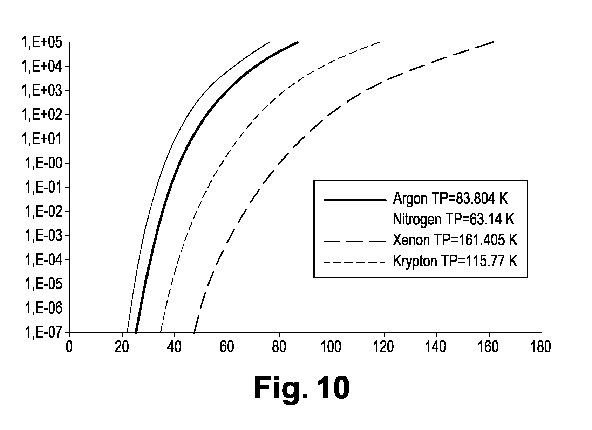

L'invention sera mieux comprise à la lecture de la description qui va suivre, donnée uniquement à titre d'exemple, et réalisée en relation avec les dessins annexés, dans lesquels des références identiques désignent des éléments identiques, et dans lesquels :
▪ la figure 1 est une vue schématique d'un système selon l'invention de production de cible pour rayons X et de production de rayons X ;
▪ les figures 2 et 3 sont respectivement des vues schématiques de dessus et en coupe d'un support pour cible selon l'invention ;
▪ les figures 4 à 9 sont des vues schématiques illustrant différentes phases de fonctionnement du système de la figure 1 en vue de mettre en oeuvre un procédé selon l'invention ; et
▪ la figure 10 est un tracé de courbes de saturation de différents gaz de matériau de remplissage pour des températures inférieures au point triple de ces gaz.

### DESCRIPTION DETAILLEE DE L'INVENTION

Il va à présent être décrit en relation avec la figure 1, un système **10** selon l'invention permettant la réalisation d'une cible métallique pour la génération de rayons X et la génération des rayons X à partir d'une seule enceinte sous vide.

Le système **10** comporte notamment :
▪ une enceinte hermétique **12** comportant une première portion de paroi formant une première fenêtre **14** transparente à un faisceau laser, et une seconde portion de paroi formant une seconde fenêtre **16** transparente à des rayons X et disposée en regard de la première fenêtre **14.** L'enceinte hermétique **12** comporte en outre un écran thermique permettant de limiter les apports de chaleur par rayonnement en provenance de l'environnement qui l'entoure et des éléments internes à l'enceinte dont la température est maintenue élevée, par exemple proche de 300 K, pour leur fonctionnement;
▪ un circuit de pompage **18** de l'enceinte **12,** apte à établir dans celle-ci une pression réduite, notamment inférieure à 10⁻³ mbar, et plus particulièrement une pression inférieure ou égale à 10⁻⁴ mbar ;
▪ un circuit d'injection **20** apte à injecter du gaz dans l'enceinte **12 ;**
▪ un circuit de contrôle de température **22** de l'enceinte **12** apte à établir dans l'enceinte **12** une température basse, notamment une température inférieure à 100 K. De manière avantageuse, le circuit **22** comporte également une source froide, préférentiellement de température inférieure à la température du point triple d'un matériau de remplissage, apte à évacuer les flux de chaleur générés dans l'enceinte **12,** notamment les flux générés par un processus de dépôt d'une couche métallique réalisé dans l'enceinte **12,** comme cela sera décrit plus en détail par la suite ; et
▪ un laser **24** apte à réaliser des tirs lasers au travers de la première fenêtre **14** selon un axe de faisceau **26.**

Le système **10** comporte également, dans l'enceinte **12** :
▪ un support **28** plan percé de part en part par des ouvertures **30 ;**
▪ un premier circuit de déplacement du support **32** apte à déplacer celui-ci de manière à positionner chacune des ouvertures **30** sur l'axe de faisceau laser **26,** comme cela sera expliqué plus en détail ci-dessous ;
▪ une plaque pleine **34,** par exemple de mêmes dimensions que le support **28;**
▪ un second circuit de déplacement et de chauffage **36,** apte à déplacer la plaque **34** entre une position de rangement, dans laquelle la plaque **34** ne perturbe pas le dépôt ultérieur d'une couche métallique sur le support **28,** et une position de protection, dans laquelle la plaque **34** est plaquée contre le support **28** de manière à fermer les ouvertures **30** et empêcher la condensation sur la face du support **28** contre laquelle est plaquée la plaque **34.** Le circuit **36** est en outre apte à chauffer la plaque **34.** Le circuit **36** est par exemple apte à délivrer un pulse de chaleur à la plaque **34** et/ou la plaque **34** est métallique et le circuit **36** est apte à injecter un courant dans celle-ci de manière à provoquer un échauffement par effet Joule ;
▪ un support **38** apte à recevoir une couche métallique à évaporer; et
▪ un circuit de chauffage **40** du support **38** pour porter le support à une température supérieure à la température d'évaporation du métal déposé sur le support **38.**

Le circuit de contrôle de température **22** comporte également un circuit de contrôle de la température du support **28,** et notamment des moyens de refroidissement du support **28,** par exemple des conduites au contact de, et/ou dans, ce dernier et dans lesquelles circule de l'hélium gazeux, et/ou un cryoréfrigérateur comportant une liaison par tresses métalliques ou par thermosiphon, et des moyens de chauffage du support **28,** par exemple un chauffage électrique régulé.

Enfin, le système **10** comporte une unité **42** commandant le fonctionnement des éléments venant d'être décrits selon plusieurs phases décrites ci-après.

En se référant aux figures 2 et 3, le support **28** prend par exemple la forme d'un disque dans lequel les ouvertures **30** sont positionnées en cercle et régulièrement espacées angulairement. De manière avantageuse, les ouvertures **30** ont des dimensions millimétriques ou inférieures au millimètre, et ont une section tronconique qui s'évase depuis la face **44** du support **28** faisant face à la fenêtre **14** de l'enceinte **12** vers la face **46** faisant face à la fenêtre **16** de l'enceinte **12,** afin de se conformer à l'angle de divergence du faisceau de rayons X produit lors de l'impact de tirs lasers.

De manière avantage, le support **28** est réalisé en silicium ou en germanium, ces matériaux étant de très bons conducteurs de chaleur, ce qui permet une commande aisée de la température du support. De plus, un support en silicium ou en germanium peut être poli de manière importante. Plus particulièrement, la face **44** du support **28** est polie de manière à présenter très peu de rugosités, et notamment présenter un poli dit « de qualité optique », ce qui permet d'obtenir un dépôt métallique ultérieur sur la face **44** d'épaisseur sensiblement constante.

Le circuit de déplacement **32** du support **28** comporte par exemple un moteur électrique pas à pas pour entrainer en rotation le support **28** autour d'un axe **48** perpendiculaire au plan principal du support **28,** et passant par le centre du cercle sur lequel sont positionnées les ouvertures **30.** Le circuit **32** permet ainsi de positionner chacune des ouvertures **30** sur l'axe **26** du faisceau laser émis par le laser **24.**

Il va à présent être décrit avec les figures 4 à 9 un procédé selon l'invention de réalisation d'une cible métallique pour la génération de rayons X et de génération des rayons X mise en oeuvre par le système **10.**

Dans une première étape du procédé, une couche métallique **60** est positionnée sur le support **38,** le métal de la couche **60** étant celui constitutif de la cible pour la génération de rayons X ultérieurement réalisée (figure 4). Le métal de la couche **60** est par exemple du tantale, du tungstène, de l'or ou du cuivre. L'unité **42** commande en outre le circuit de déplacement et de chauffage **36** de manière à plaquer la plaque **34** contre le support **28.**

Consécutivement, ou parallèlement, l'unité **42** commande le circuit de pompage **18** et le circuit de contrôle de température **22** afin d'établir et de maintenir une pression et une température dans l'enceinte **12** telles :
▪ que le support **28** et la plaque **34** présentent une température inférieure à la température du point triple d'un matériau de remplissage des ouvertures **30** introduit ultérieurement dans l'enceinte **12** sous forme gazeuse ; et
▪ que la pression dans l'enceinte **12** est maintenue à une pression inférieure à la pression de vapeur saturante du matériau de remplissage correspondant à la température du support **28** afin d'éviter toute condensation parasite.

Une fois la pression et la température de l'enceinte **12** réglées, l'unité **42** commande alors le circuit d'injection **20** pour que ce dernier injecte dans l'enceinte **12** le matériau de remplissage **62** sous forme gazeuse. Le matériau de remplissage **62** est notamment de l'argon, de l'azote, du krypton, du xénon, ou un mélange de ceux-ci. En raison des conditions de pression et de température dans l'enceinte **12** qui sont réglées en fonction du gaz injecté **62,** ce dernier se condense sous forme solide dans les ouvertures **30.**

Une fois les ouvertures **30** remplies par le matériau solide **62,** l'unité **42** commande l'arrêt de l'injection du gaz dans l'enceinte **12.** De manière avantageuse, l'unité **42** commande le circuit de pompage **18** afin de baisser la pression dans l'enceinte **12** et le circuit de contrôle de température **22** afin de baisser la température du support **28** de quelques kelvins afin de garantir le maintien des bouchons à l'état solide lors d'un afflux ultérieur de chaleur en provenance de la plaque **34** et d'un dépôt métallique sur le support **28** et éviter l'auto-évaporation des bouchons.

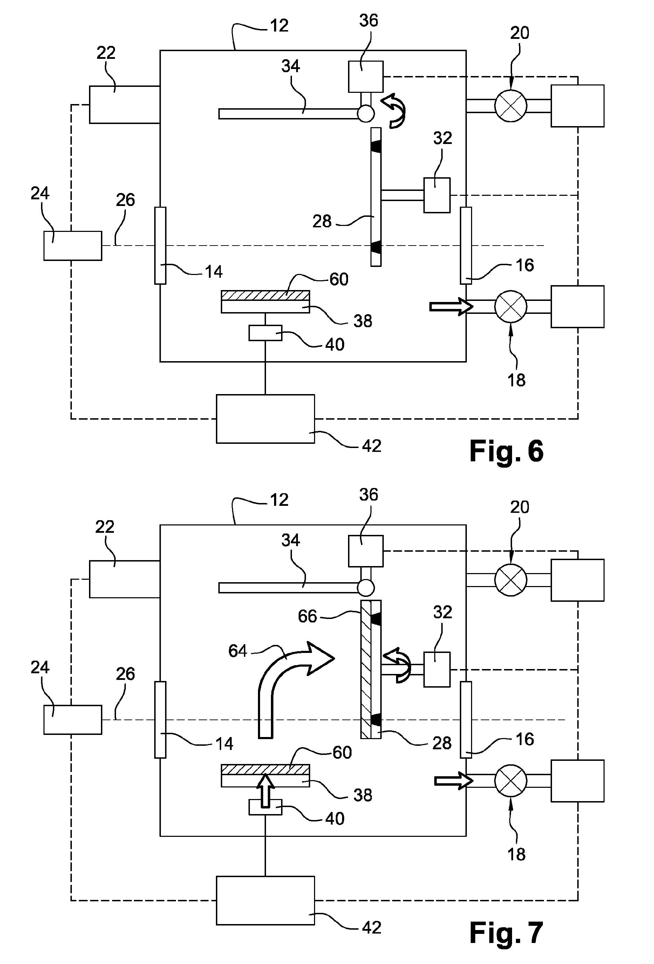

L'unité **42** commande ensuite le circuit de déplacement et de chauffage **36** de manière à ce que ce dernier chauffe la plaque **34.** La plaque **34** se décolle alors du matériau **62** remplissant les ouvertures **30** du support **28** (figure 5). L'unité **42** commande ensuite le circuit de déplacement et de chauffage **36** de manière à positionner la plaque **34** dans sa position de rangement (figure 6).

Lors d'une étape suivante, l'unité **42** commande le circuit de chauffage **40** de manière à ce que la température du support **38** soit supérieure à la température d'évaporation du métal de la couche **60** reposant sur le support **38.** Un dépôt physique en phase vapeur est alors mis en oeuvre. Plus particulièrement, le métal vaporisé **64** se dépose sur la face **44** du support **28** et sur les bouchons de matériau solide **62** remplissant les ouvertures **30** (figure 7), formant ainsi une couche métallique **66.**

Une fois l'épaisseur souhaitée pour la couche métallique **66** obtenue, notamment une épaisseur inférieure ou égale à 500 nanomètres, et de préférence une épaisseur inférieure ou égale à 50 nanomètres, de manière à mettre en oeuvre une émission de rayons X par transmission, l'unité **42** commande l'arrêt du chauffage du support **38** et par conséquent l'arrêt du dépôt métallique sur le support **28.**

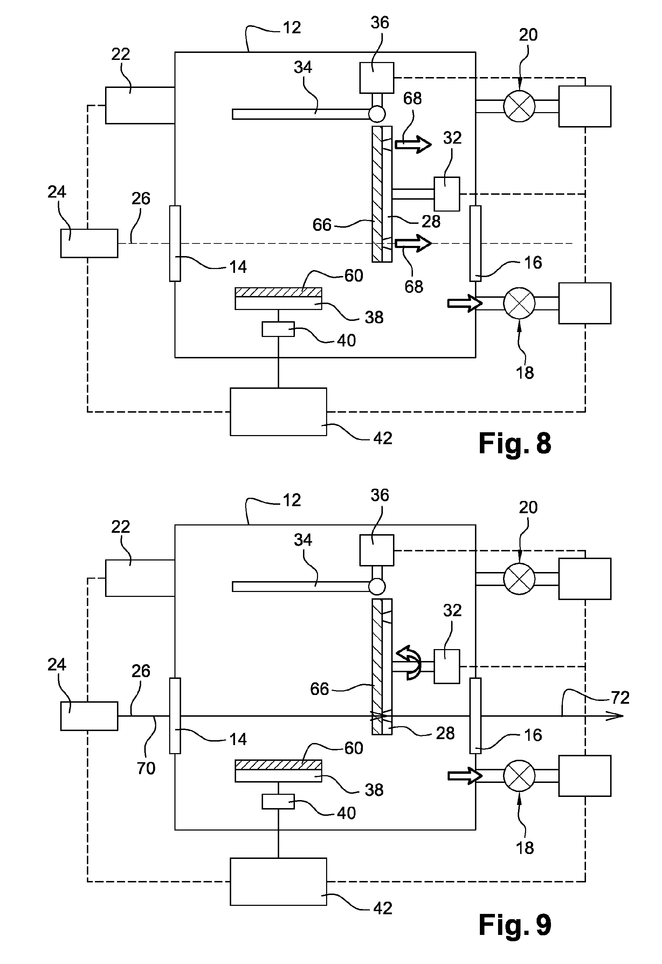

L'unité **42** commande ensuite le circuit de pompage **18** et le circuit de contrôle de température **22** de manière à faire disparaître le matériau **62** remplissant les ouvertures **30** du support **28,** de préférence par sublimation. Plus particulièrement, l'unité **42** commande le circuit **22** pour régler la température du support **28** à une température supérieure à la température de vapeur saturante du matériau de remplissage correspondant à la pression dans l'enceinte **12** maintenue constante. En pratiquant de la sorte, la température des bouchons solides traverse la courbe de pression de vapeur saturante du matériau de remplissage tel que cela est illustré à la figure **10****,** de sorte que les bouchons solide se subliment. Le matériau sublimé **68** est alors pompé par le circuit de pompage **18** et évacué de l'enceinte **12** (figure 8).

Enfin, une fois les ouvertures **30** libérées du matériau de remplissage **62,** l'unité **42** commande le laser **24** et le circuit de déplacement **32** pour provoquer l'émission de tir laser **70** au travers de la fenêtre **14** sur les portions de la couche métallique **66** disposées sur les ouvertures **30** du support **28,** notamment sur des portions vierges de tout impact. Pour chaque tir laser, il est alors produit un faisceau de rayons X monochromatiques **72** selon l'axe **26** du faisceau laser, ledit faisceau étant émis vers l'extérieur de l'enceinte **12** au travers de la fenêtre **16.**

Par exemple, pour un matériau de remplissage constitué d'argon, la température du support **28** et de la plaque **34** est choisie dans la gamme [30K, 40K] et la pression de l'enceinte est choisie sensiblement égale à 10⁻⁴ mbar.

De manière avantageuse, le choix du matériau de remplissage et le choix des réglages de la pression de l'enceinte et de la température du support sont réalisés de la manière suivante. Tout d'abord, le matériau de remplissage est sélectionné en fonction du support **28** afin d'obtenir un dépôt métallique homogène. Notamment, si le support comporte un réseau cristallin, le matériau de remplissage est choisi pour que sa phase solide soit également cristalline de sorte que le dépôt métallique de la cible soit réalisé sur une surface homogène. Une fois le matériau de remplissage choisi, la température du support est choisie pour une pression de l'enceinte inférieure à 10⁻³ mbar, par exemple 25 K pour l'azote, 35 K pour l'argon, 52 K pour le Xénon ou 75 K pour le krypton et le gaz de matériau de remplissage est introduit dans l'enceinte. La pression de l'enceinte est alors augmentée, notamment pour être comprise entre 10⁻³ mbar et 5 10⁻³ mbar afin de solidifier le gaz et remplir les ouvertures du support. Une fois les ouvertures remplies, l'injection de gaz est stoppée et la pression est de nouveau abaissée à une valeur inférieure à 10⁻³ mbar. Durant le dépôt métallique de la cible sur le support, la température est abaissée de quelques kelvins et la pression dans l'enceinte est abaissée de quelques 10⁻⁴ mbar afin de limiter les phénomènes d'évaporation par afflux de chaleur et d'auto évaporation. Quand le dépôt de la cible sur le support est terminé, la température du support est alors relevée de quelques kelvins pour provoquer la sublimation du matériau de remplissage présent dans les ouvertures.

Dans une première variante, lorsque la cible **66** est usagée, l'enceinte **12** est ouverte, et le support **28** avec la cible usagée **66** sont retirées. Un nouveau support **28** est alors introduit dans l'enceinte **12** pour un nouveau cycle de fabrication d'un cible et de production de rayons X tel que décrit précédemment.

Dans une seconde variante, le circuit **22** de commande de la température du support **28** est apte à élever la température de ce dernier pour provoquer l'évaporation totale de la cible usagée **66.** Le métal évaporé est alors pompé par le circuit de pompage **18** et un nouveau cycle de fabrication d'une cible peut alors être mis en oeuvre sans avoir à casser le vide dans l'enceinte **12.**

Il a été décrit un mode de réalisation particulier dans lequel le support de la cible comprend des ouvertures selon un agencement particulier. Bien entendu, l'invention s'applique à tout type de support et d'agencement d'ouvertures.

Il a été décrit une plaque qui est plaquée contre le support lors du remplissage des ouvertures afin, notamment, de protéger la face du support sur laquelle est ultérieurement déposée la cible de la condensation. D'autres éléments de protection peuvent cependant être envisagés. Notamment, un second élément de protection mobile, par exemple une seconde plaque pleine, est prévue pour être plaquée contre la face du support **28** opposée à la face contre laquelle l'élément de protection **34** est apte à être plaqué. Le second élément de protection est plaqué contre le support **28** lors du dépôt de la couche métallique de manière à protéger la face arrière d'un dépôt parasite sur les bouchons remplissant les ouvertures **30.** Le second élément de protection est avantageusement relié à un circuit de déplacement et de chauffage pour déplacer et chauffer celui-ci.

De même, il a été décrit un mode de réalisation dans lequel la formation des bouchons solides dans les ouvertures du support de la cible, le retrait de la plaque de protection et le dépôt de la cible sur le support sont réalisés avec uns pression et une température constantes. Lors de ces phases, la pression et la température peuvent varier dans toute gamme permettant de conserver sous leur forme solide les bouchons remplissant les ouvertures du support. De manière analogue, des températures et des pressions différentes peuvent être choisies lors de la génération des rayons X.

Il a été décrit le dépôt d'un unique matériau métallique sur le support **28.** En variante, plusieurs couches métalliques sont déposées successivement sur le support **28.** A cet effet, le système selon l'invention comporte par exemple plusieurs supports **38** contrôlés en température indépendamment les uns des autres par un circuit de chauffage **40** prévu pour, et connecté à, chaque supports **38** ou par un unique circuit de chauffage **40** connecté à chaque support **38.** Différents matériaux métalliques peuvent ainsi être déposés sur les supports **38,** et l'unité **42** commande le ou les circuits de chauffage **40** de manière à déposer des couches métalliques successives sur le support **28** dans un ordre prédéterminé. Une fois, le dépôt des différentes couches métalliques réalisé, le matériau de remplissage présent dans les ouvertures **30** du support **28** est alors retiré, tel que décrit précédemment, et les tirs laser peuvent avoir lieu.

En variante ou de manière additionnelle, une fois une couche métallique déposée, par exemple la première couche, le second élément de protection est plaqué contre le support **28,** par exemple après que les bouchons remplissant les ouvertures **30** du support **28** aient été retirés, avant le dépôt de la ou des couches métalliques suivantes, ce qui permet notamment d'éviter le dépôt de métal dans les ouvertures **30.** De cette manière, les conditions de dépôts sont plus libres dans la mesure où il n'est plus nécessaire de régler la pression et la température dans l'enceinte pour conserver les bouchons solides.

Par exemple, la ou les couches de métal suivantes peuvent être déposées par condensation sous forme solide d'un gaz injecté dans l'enceinte via le circuit d'injection **20,** la pression et la température de l'enceinte étant contrôlées pour obtenir cette condensation.

Il a été décrit la réalisation d'une cible métallique pour la génération de rayon X. L'invention s'applique également à la fabrication de cibles ultra-minces non métalliques ou partiellement métalliques, telles que par exemple les cibles utilisées dans les accélérateurs de particules. Par exemple, les cibles comportent une couche de dihydrogène ou de deutérium solide en plus, ou à la place de, d'une couche métallique. Les tirs lasers sur une telle cible génèrent ainsi des protons et/ou des électrons.

Notamment, une couche métallique, d'une épaisseur comprise entre 20 nanomètres et 100 nanomètres, est déposée sur le support **28,** puis une seconde couche de dihydrogène ou de deutérium solide, d'une épaisseur comprise entre 20 nanomètres et 100 nanomètres, est déposée sur la couche métallique. Le dépôt de multiples matériaux sur le support **28** est par exemple réalisé en déposant la couche de dihydrogène ou de deutérium sur la couche métallique une fois les bouchons remplissant les ouvertures **30** ôtés et le second élément de protection plaqué contre le support **28.**

## Revendications

1. Procédé de fabrication d'une cible (66) pour la génération de rayonnements de photons, notamment de rayons X, ou de particules, notamment de protons ou d'électrons, par laser, comportant :
• la réalisation d'un support (28) comprenant une première et une seconde faces (44, 46) et traversé par des ouvertures (30) ; et
• la formation dans une enceinte hermétique (12) d'une couche de matériau (66) sur la première face (44) du support (28),
***caractérisé* en ce que** la formation de la couche de matériau (66) sur le support (28) comporte :
▪ la protection de la première face (44) du support (28) par un élément de protection (34);
▪ l'injection dans l'enceinte (12) d'un gaz de matériau de remplissage (62);
▪ le réglage de la pression dans l'enceinte et de la température du support (28) de manière à former des bouchons solides de matériau de remplissage dans les ouvertures (30) du support (28);
▪ l'arrêt de l'injection du gaz de matériau de remplissage (62) dans l'enceinte (12);
▪ le maintien de la température du support (28) et de la pression de l'enceinte à des valeurs conservant les bouchons solides dans les ouvertures (30) du support (28), et conjointement audit maintien :
o le retrait de l'élément de protection (34) de la première face (44) du support (28) de manière à libérer celle-ci; et
o la formation de la couche de matériau (66) sur la première face (44) du support (28) et sur les bouchons solides remplissant les ouvertures (30) ;
▪ la modification des conditions de pression dans l'enceinte et de température du support de manière à libérer les ouvertures (30) du support (28) des bouchons solides.

2. Procédé de fabrication d'une cible (66) selon la revendication 1, ***caractérisé* en ce que** la première face (44) du support est plane, et **en ce que** la protection de celle-ci comprend le plaquage de la première face (44) du support (28) contre une surface plane et pleine (34).

3. Procédé de fabrication d'une cible (66) selon la revendication 1 ou 2, ***caractérisé* en ce que** la formation des bouchons solides comporte le réglage de la pression dans l'enceinte (12) à une pression prédéterminée et le refroidissement du support (28) à une température inférieure à la température du point triple du matériau constitutif du gaz (62).

4. Procédé de fabrication d'une cible (66) selon l'une quelconque des revendications précédentes, ***caractérisé* en ce que** la couche de matériau (66) est déposée sur la première face (44) du support (28) au moyen d'un dépôt physique en phase vapeur.

5. Procédé de fabrication d'une cible (66) selon l'une quelconque des revendications précédentes, ***caractérisé* en ce que** l'enceinte hermétique (12) comporte des moyens (20) aptes à injecter le gaz dans l'enceinte (12), des moyens (18) aptes à régler la pression interne de celle-ci, des moyens (22) aptes à régler la température du support (28) à des températures inférieures au point triple du matériau constitutif du gaz, et des moyens (38, 40) aptes à vaporiser un élément métallique solide placé au contact de ceux-ci, et **en ce que** la mise en contact du support (28) avec le gaz (62), la formation des bouchons remplissant les ouvertures (30) du support (28) et le dépôt physique en phase vapeur sont réalisés dans l'enceinte (12) en maintenant une pression réduite, notamment inférieure à 10⁻³ mbar.

6. Procédé de fabrication d'une cible (66) selon l'une quelconque des revendications précédentes, ***caractérisé* en ce que** le retrait de l'élément de protection (34) de la première face (44) du support (28) comprend l'échauffement de ce dernier de manière à désolidariser l'élément (34) des bouchons solides remplissant les ouvertures (30) du support (28) et l'éloignement de l'élément de protection (34) de la première face (44) du support (28).

7. Procédé de fabrication d'une cible (66) selon l'une quelconque des revendications précédentes, ***caractérisé* en ce que** la libération des ouvertures (30) du support (28) comporte le réglage de la température du support (28) et/ou de la pression du gaz (62) de manière à sublimer les bouchons solides..

8. Procédé de fabrication d'une cible (66) selon l'une quelconque des revendications précédentes, ***caractérisé* en ce que** le matériau de remplissage (62) est de l'argon, de l'azote, du krypton, ou du xénon.

9. Procédé de fabrication d'une cible (66) selon l'une quelconque des revendications précédentes, ***caractérisé* en ce que** la couche de matériau (66) est une couche métallique.

10. Procédé de fabrication d'une cible métallique (66) selon la revendication 9, ***caractérisé* en ce que** l'épaisseur de la couche de matériau (66) est inférieure ou égale à 500 nanomètres, et de préférence inférieure ou égale à 50 nanomètres.

11. Procédé de fabrication d'une cible (66) selon l'une quelconque des revendications 1 à 8, ***caractérisé* en ce que** la couche de matériau (66) comporte une couche métallique et une couche de dihydrogène ou de deutérium.

12. Procédé de fabrication d'une cible (66) selon la revendication 11, ***caractérisé* en ce que** la couche métallique a une épaisseur comprise entre 20 nanomètres et 100 nanomètres, et **en ce que** la couche de dihydrogène ou de deutérium a une épaisseur comprise entre 20 nanomètres et 100 nanomètres.

13. Procédé de fabrication d'une cible (66) selon l'une quelconque des revendications précédentes, ***caractérisé* en ce que** les ouvertures (30) du support (28) sont des cônes tronqués s'évasant depuis la première face (44) du support (28) vers la seconde face (46) du support (28).

14. Procédé de fabrication d'une cible (66) selon l'une quelconque des revendications précédentes, ***caractérisé* en ce que** des ouvertures (30) du support (28) sont disposées en cercle et angulairement espacées de manière régulière.

15. Système pour la mise en oeuvre d'un procédé de fabrication d'une cible (66) pour la génération de rayonnements de photons, notamment de rayons X ou de particules, notamment de protons ou d'électrons par laser conforme à l'une quelconque des revendications précédentes, comportant :
▪ une enceinte hermétique (12) ;
▪ un support (28) et des moyens (32) de positionnement du support (28) dans l'enceinte (12) ;
▪ un élément de protection (34) et des moyens (36) de positionnement de l'élément de protection (34) dans l'enceinte (12) entre une position de retrait et une position de plaquage de l'élément de protection (34) contre la face (44) du support (28) ;
▪ des moyens (18) de pompage du volume interne de l'enceinte ;
▪ des moyens (22) de commande de la température du support ;
▪ des moyens (20) d'injection de gaz dans l'enceinte
▪ des moyens (36) de chauffage de l'élément de protection (34) ; et
▪ des moyens (38, 40) de vaporisation d'un élément métallique dans l'enceinte (12).

16. Système selon la revendication 15, ***caractérisé* en ce que** les moyens (32) de positionnement du support (28) dans l'enceinte (12) comportent des moyens de mise en rotation de ce dernier.

17. Système selon la revendication 15 ou 16, ***caractérisé* en ce que** l'enceinte (12) comporte une fenêtre transparente (14) au faisceau laser disposée en regard de la face (44) du support (28).

## Patentansprüche

1. Verfahren zur Herstellung eines Targets (66) für die Erzeugung von Photonenstrahlung, insbesondere von Röntgenstrahlen, oder von Partikeln, insbesondere von Protonen oder Elektronen, mittels Laser, umfassend:
- die Herstellung eines Trägers (28), der eine erste und eine zweite Seite (44, 46) und durchgehende Öffnungen (30) aufweist, und
- die Bildung einer Stoffschicht (66) auf der ersten Seite (44) des Trägers (28) in einem abgedichteten Raum (12),
**dadurch gekennzeichnet, dass** die Bildung der Stoffschicht (66) auf dem Träger (28)
- den Schutz der ersten Seite (44) des Trägers (28) durch ein Schutzelement (34),
- die Einspeisung eines Füllstoffgases (62) in den Raum (12),
- die Regelung des Drucks in dem Raum und der Temperatur des Trägers (28), um feste Füllstoffpfropfen in den Öffnungen (30) des Trägers (28) zu bilden,
- die Unterbrechung der Einspeisung von Füllstoffgas (62) in den Raum (12),
- die Aufrechterhaltung der Temperatur des Trägers (28) und des Drucks des Raums bei Werten, bei denen die festen Pfropfen in den Öffnungen (30) des Trägers (28) verbleiben, und gemeinsam mit dieser Aufrechterhaltung:
o das Entfernen des Schutzelements (34) von der ersten Seite (44) des Trägers (28), um diese freizulegen, und
o die Bildung der Stoffschicht (66) auf der ersten Seite (44) des Trägers (28) und auf den festen, die Öffnungen (30) füllenden Pfropfen,
- die Änderung der Druckverhältnisse in dem Raum und der Trägertemperatur, um die Öffnungen (30) des Trägers (28) von den festen Pfropfen zu befreien,
umfasst.

2. Verfahren zur Herstellung eines Targets (66) nach Anspruch 1, **dadurch gekennzeichnet, dass** die erste Seite (44) des Trägers eben ist und dass ihr Schutz das Anlegen der ersten Seite (44) des Trägers (28) an eine ebene Vollfläche (34) umfasst.

3. Verfahren zur Herstellung eines Targets (66) nach Anspruch 1 oder 2, **dadurch gekennzeichnet, dass** die Bildung der festen Pfropfen die Einstellung des Drucks in dem Raum (12) auf einen vorbestimmten Druck und die Kühlung des Trägers (28) auf eine Temperatur beinhaltet, die geringer ist als die Temperatur des Tripelpunktes des Stoffs, aus dem das Gas (62) besteht.

4. Verfahren zur Herstellung eines Targets (66) nach einem beliebigen der vorhergehenden Ansprüche, **dadurch gekennzeichnet, dass** die Stoffschicht (66) mittels physikalischer Dampfabscheidung auf die erste Seite (44) des Trägers (28) aufgebracht wird.

5. Verfahren zur Herstellung eines Targets (66) nach einem beliebigen der vorhergehenden Ansprüche, **dadurch gekennzeichnet, dass** der abgedichtete Raum (12) Mittel (20) aufweist, die geeignet sind, das Gas in den Raum (12) einzuspeisen, Mittel (18), die geeignet sind, den inneren Druck des Raums zu regeln, Mittel (22), die geeignet sind, die Temperatur des Trägers (28) auf Temperaturen einzustellen, die geringer sind als der Tripelpunkt des Stoffs, aus dem das Gas besteht, und Mittel (38, 40), die geeignet sind, ein festes metallisches in Kontakt mit diesen gebrachtes Element zu verdampfen, und dass die Inkontaktbringung des Trägers (28) mit dem Gas (62), die Bildung der die Öffnungen (30) des Trägers (28) füllenden Pfropfen und die physikalische Dampfabscheidung in dem Raum (12) bei Aufrechterhaltung eines verringerten Drucks, der insbesondere geringer als 10⁻³ mbar ist, erfolgen.

6. Verfahren zur Herstellung eines Targets (66) nach einem beliebigen der vorhergehenden Ansprüche, **dadurch gekennzeichnet, dass** das Entfernen des Schutzelements (34) von der ersten Seite (44) des Trägers (28) das Erhitzen des Letzteren umfasst, so dass das Element (34) von den festen, die Öffnungen (30) des Trägers (28) füllenden Pfropfen getrennt wird und das Schutzelement (34) von der ersten Seite (44) des Trägers (28) beabstandet wird.

7. Verfahren zur Herstellung eines Targets (66) nach einem beliebigen der vorhergehenden Ansprüche, **dadurch gekennzeichnet, dass** die Freilegung der Öffnungen (30) des Trägers (28) die Regelung der Temperatur des Trägers (28) und/oder des Drucks des Gases (62) derart, dass die festen Pfropfen sublimiert werden, umfasst.

8. Verfahren zur Herstellung eines Targets (66) nach einem beliebigen der vorhergehenden Ansprüche, **dadurch gekennzeichnet, dass** es sich bei dem Füllstoff (62) um Argon, Stickstoff, Krypton oder Xenon handelt.

9. Verfahren zur Herstellung eines Targets (66) nach einem beliebigen der vorhergehenden Ansprüche, **dadurch gekennzeichnet, dass** es sich bei der Stoffschicht (66) um eine metallische Schicht handelt.

10. Verfahren zur Herstellung eines Targets (66) nach Anspruch 9, **dadurch gekennzeichnet, dass** die Dicke der Stoffschicht (66) geringer als oder gleich 500 Nanometer, vorzugsweise geringer als oder gleich 50 Nanometer ist.

11. Verfahren zur Herstellung eines Targets (66) nach einem beliebigen der Ansprüche 1 bis 8, **dadurch gekennzeichnet, dass** die Stoffschicht (66) eine metallische Schicht und eine Schicht aus molekularem Wasserstoff oder Deuterium aufweist.

12. Verfahren zur Herstellung eines Targets (66) nach Anspruch 11, **dadurch gekennzeichnet, dass** die metallische Schicht eine Dicke zwischen 20 Nanometer und 100 Nanometer aufweist und dass die Schicht aus molekularem Wasserstoff oder Deuterium eine Dicke zwischen 20 Nanometer und 100 Nanometer aufweist.

13. Verfahren zur Herstellung eines Targets (66) nach einem beliebigen der vorhergehenden Ansprüche, **dadurch gekennzeichnet, dass** die Öffnungen (30) des Trägers (28) Kegelstümpfe sind, die sich von der ersten Seite (44) des Trägers (28) in Richtung der zweiten Seite (46) des Trägers (28) ausweiten.

14. Verfahren zur Herstellung eines Targets (66) nach einem beliebigen der vorhergehenden Ansprüche, **dadurch gekennzeichnet, dass** Öffnungen (30) des Trägers (28) kreisförmig angeordnet und regelmäßig winklig beabstandet sind.

15. System zur Umsetzung eines Verfahren zur Herstellung eines Targets (66) für die Erzeugung von Photonenstrahlung, insbesondere von Röntgenstrahlen, oder von Partikeln, insbesondere von Protonen oder Elektronen, mittels Laser nach einem beliebigen der vorhergehenden Ansprüche, umfassend:
- einen abgedichteten Raum (12),
- einen Träger (28) und Mittel (32) für die Positionierung des Trägers (28) in dem Raum (12),
- ein Schutzelement (34) und Mittel (36) für die Positionierung des Schutzelements (34) in dem Raum (12) zwischen einer Entfernungsstellung und einer Stellung, in der das Schutzelement (34) an die Seite (44) des Trägers (28) angelegt ist,
- Mittel (18) zum Auspumpen des inneren Raumvolumens,
- Mittel (22) für die Steuerung der Temperatur des Trägers,
- Mittel (20) zum Einspeisen von Gas in den Raum,
- Mittel (36) zum Heizen des Schutzelements (34) und
- Mittel (38, 40) zum Verdampfen eines metallischen Elements in dem Raum (12).

16. System nach Anspruch 15, **dadurch gekennzeichnet, dass** die Mittel (32) für die Positionierung des Trägers (28) in dem Raum (12) Mittel aufweisen, um diesen in eine Drehbewegung zu versetzen.

17. System nach Anspruch 15 oder 16, **dadurch gekennzeichnet, dass** der Raum (12) ein Fenster (14) aufweist, das für den Laserstrahl transparent ist und gegenüber der Seite (44) des Trägers (28) angeordnet ist.

## Claims

1. A method of manufacturing a target (66) for the generation of radiation of photons, particularly of X rays, or of particles, particularly of protons or electrons, by means of a laser, comprising:
• forming a support (28) comprising a first and a second surfaces (44, 46) and crossed by openings (30); and
• forming in a tight enclosure (12) a layer of material (66) on the first surface (44) of the support (28),
wherein the forming of the layer of material (66) on the support (28) comprises:
▪ protecting the first surface (44) of the support (28) with a protection element (34);
▪ injecting into the enclosure (12) a gas of filling material (62);
▪ adjusting the pressure in the enclosure and the temperature of the support (28) to form the solid plugs of filling material in the openings (30) of the support (28);
▪ stopping the injection of the gas of filling material (62) into the enclosure (12);
▪ maintaining the temperature of the support (28) and the pressure in the enclosure at values keeping the plugs solid in the openings (30) of the support (28) and, jointly to said maintaining:
o withdrawing the protection element (34) from the first surface (44) of the support (28) to expose said surface; and
o forming the layer of material (66) on the first surface (44) of the support (28) and on the solid plugs filling the openings (30);
▪ modifying the conditions of pressure in the enclosure and of support temperature to clear the openings (30) of the support (28) of the solid plugs.

2. The method of manufacturing a target (66) of claim 1, wherein the first surface (44) of the support is planar, and in that the protection thereof comprises placing the first surface (44) of the support (28) against a planar solid surface (34).

3. The method of manufacturing a target (66) of claim 1 or 2, wherein the forming of the solid plugs comprises adjusting the pressure in the enclosure (12) to a predetermined pressure and cooling the support (28) to a temperature lower than the temperature of the triple point of the material forming the gas (62).

4. The method of manufacturing a target (66) of any of the foregoing claims, wherein the layer of material (66) is deposited on the first surface (44) of the support (28) by means of a physical vapor deposition.

5. The method of manufacturing a target (66) of any of the foregoing claims, wherein the tight enclosure (12) comprises means (20) capable of injecting gas into the enclosure (12), means (18) capable of adjusting the internal pressure thereof, means (22) capable of adjusting the temperature of the support (28) to temperatures lower than the triple point of the material forming the gas, and means (38, 40) capable of vaporizing a solid metal element placed in contact therewith, and wherein the placing into contact of the support (28) with the gas (62), the forming of the plugs filling the openings (30) of the support (28), and the physical vapor deposition are performed in the enclosure (12) while maintaining a low pressure, particularly lower than 10⁻³ mbar.

6. The method of manufacturing a target (66) of any of the foregoing claims, wherein the withdrawal of the protection element (34) from the first surface (44) of the support (28) comprises heating said support to separate the element (34) from the solid plugs filling the openings (30) of the support (28) and drawing the protection element (34) away from the first surface (44) of the support (28).

7. The method of manufacturing a target (66) of any of the foregoing claims, wherein the clearing of the openings (30) of the support (28) comprises adjusting the temperature of the support (28) and/or the pressure of the gas (62) to sublimate the solid plugs..

8. The method of manufacturing a target (66) of any of the foregoing claims, wherein the filling material (62) is argon, nitrogen, krypton, or xenon.

9. The method of manufacturing a target (66) of any of the foregoing claims, wherein the layer of material (66) is a metal layer.

10. The method of manufacturing a target (66) of claim 9, wherein the thickness of the layer of material (66) is smaller than or equal to 500 nanometers, and preferably smaller than or equal to 50 nanometers.

11. The method of manufacturing a target (66) of any of claims 1 to 8, wherein the layer of material (66) comprises a metal layer and a dihydrogen or deuterium layer.

12. The method of manufacturing a target (66) of claim 11, wherein the metal layer has a thickness between 20 nanometers and 100 nanometers, and wherein the dihydrogen or deuterium layer has a thickness between 20 nanometers and 100 nanometers.

13. The method of manufacturing a target (66) of any of the foregoing claims, wherein the openings (30) of the support (28) are truncated cones widening from the first surface (44) of the support (28) to the second surface (46) of the support (28).

14. The method of manufacturing a target (66) of any of the foregoing claims, wherein the openings (30) of the support (28) are arranged in a circle and angularly spaced apart in regular fashion.

15. A system for implementing the method of manufacturing a target (66) for the generation of radiation of photons, particularly of X rays or particles, particularly of protons or electrons by means of a laser of any of the foregoing claims, comprising:
▪ a tight enclosure (12);
▪ a support (28) and means (32) for positioning the support (28) in the enclosure (12);
▪ a protection element (34) and means (36) for positioning the protection element (34) in the enclosure (12) between a withdrawal position and a position where the protection element (34) is placed against the surface (44) of the support (28);
▪ means (18) for pumping the internal volume of the enclosure;
▪ means (22) for controlling the support temperature;
▪ means (20) for injecting gas into the enclosure;
▪ means (36) for heating the protection element (34); and
▪ means (38, 40) for vaporizing a metallic element in the enclosure (12).

16. The system of claim 15, wherein the means (32) for positioning the support (28) in the enclosure (12) comprise means for rotating said support.

17. The system of claim 15 or 16, wherein the enclosure (12) comprises a window (14) transparent to the laser beam arranged in front of the surface (44) of the support (28).
